# EUROPEAN PATENT APPLICATION

(11) **EP 1 306 909 A1**
(43) Date of publication of application: **02.05.2003**
(21) Application number: 01870226.6
(22) Date of filing: 24.10.2001
(51) Int. Cl.: H01L 51/20

(54) **Ambipolar organic transistors**

(71) Applicant: Interuniversitair Micro-Elektronica Centrum, 3001 Heverlee (BE); LIMBURG UNIVERSITEIT CENTRUM, B-3610 Diepenbeek (BE); AGFA-GEVAERT, 2640 Mortsel (BE)
(72) Inventor: Geens, Wim, 2860 Sint-Katelijne-Waver (BE); Poortmans, Jef, 3010 Kessel-Lo (BE); Aernouts, Tom, 3120 Temelo (BE); Andriessen, Hieronymus, 2340 Beerse (BE); Vanderzande, Dirk, 3500 Hasselt (BE)
(74) Representative: Van Malderen, Joelle

(57) **Abstract**

The present invention is related to an organic field-effect transistor comprising source and drain electrodes (1) formed separately from each other on a substrate, said substrate comprising at least an organic semiconductor layer (2) constituting a channel between said source and drain electrodes (1), an insulation layer (3) underlying said organic semiconductor layer (2) and a gate electrode (4) formed on the opposite side of the isolation layer (3), wherein said organic semiconductor layer (2) comprises holes and electrons transporters, said electron transporter comprising (6,6)-phenyl C₆₁-butyric acid methyl ester (PCBM) and wherein said hole transporters comprising poly(2-methoxy-5-(3',7'-dimethyloctyloxy)-1,4-phenylene-vinylene)(OC₁C₁₀-PPV) and/or poly(3-hexylthiophene) (P3HT).

## Description

### Field of the invention

The present invention is related to microelectronics and more particularly to ambipolar organic field-effect transistors comprising organic active layer material.

### State of the art

Organic transistors and more particularly thin film field-effect transistors become more and more attractive in electronics because of their low-cost deposition technologies and steadily improving performance.

An organic field-effect transistor consists of materials ranging from conductors and semiconductors, to insulators.

A transistor is namely p-channel if the majority charge carriers in the channel are positive (holes), and conversely n-channel when the majority charge carriers in the channel are negative (electrons).

Complementary circuits consist of both n-channel and p-channel transistors. They are particularly useful because of advantages such as low static power dissipation and simple circuit design.

For the fabrication of organic complementary circuits the organic semiconducting p-channel and n-channel materials should exhibit relatively high and comparable mobility values for holes as well as for electrons.

Ambipolar operation has been observed in organic field-effect transistors based on ultra-pure pentacene single crystals (Schön *et al.,* Science, Vol. 287 (2000) p1022-1023).

In the single crystals, which were grown by physical vapour transport in a stream of nitrogen, accumulation (p-type) and inversion (n-type) could be established.

However, low-cost solution-processable complementary circuits require the use of two different organic materials to obtain n-channel and p-channel transistors, since defects in these materials only allow unipolar charge transport.

There are several reasons why only a limited number of high performance n-channel organic semiconductors have been discovered so far, one of them is the fact that most organic materials tend to transport holes better than electrons and a large research effort is ongoing on electron transporters. In this field the major difficulty is to find a material which is not sensitive to oxygen. Oxygen is known to be an efficient trap for electrons.

Recent developments disclose organic transistor structures, comprising a mix of two active materials which enables p-channel and n-channel operations in the same device. An example of such active materials exhibiting such properties are poly(3-hexylthiophene) (P3HT) and N,N'-bis(2,5-di*-tert*-butylphenyl)-3,4,9,10-perylene dicarboximide (BPPC) as respectively hole and electron transporters.(Tada *et al.,* Jpn. J. Appl. Phys., Vol. 36 (1997) Pt. 2, No. 6A, L718). Currents of both polarities can be injected from the source and the drain contacts.

Such transistors are n-channel under positive gate bias and p-channel under negative gate bias. Hole and electron mobilities of respectively < 10⁻⁶ cm₂/(Vs) and < 10⁻⁷ cm²/(Vs) were reported for P3HT doped with a 25 mol % concentration of BPPC.

Balberg describes in Applied Physical Letters ,Vol.79,No.2,9 July 2001 a fullerene (C₆₀)-polymer network composite structure showing as well a connectivity of a percolative C₆₀ network and additionally a connectivity of the polymer network. The effectivity of the coupling phenomenon and the recombination kinetics depends on the molar fractions of both components.

Brown discloses in U.S.Patent 5,629,530 a solid state mixture of organic donor and acceptor molecules different of the present invention and encounters some difficulties to obtain good balanced mobility values for holes and electrons transports in his organic donor/acceptor layer.

Dodabalapur discloses in U.S.Patent 5,596,208 organic field-effect transistors based on superposed evaporated organic n-type and p-type layers. In this patent evaporated C₆₀ molecules are used as electron transporters in combination with Cr/Au bottom contacts. This technology leads to high production costs and this is a major disadvantage for organic transistors which are especially developed for low cost applications.

### Aims of the invention

The present invention aims to provide a network of organic molecules providing high balanced mobility values for holes and electrons combined to single top contacts for low-cost large scale organic ambipolar transistor productions.

### Summary of the invention

The present invention discloses a thin film ambipolar organic metal oxide semiconductor field-effect transistor (MOSFET) comprising source and drain contacts and an organic semiconductor layer, said layer comprises hole and electron transporter, characterised in that said electron transporter comprises (6,6)-phenyl C₆₁-butyric acid methyl ester (PCBM) and said hole transporter comprises poly(2-methoxy-5-(3',7'-dimethyloctyloxy)-1,4-phenylene-vinylene) (OC₁C₁₀-PPV) and/or poly(3-hexylthiophene)(P3HT)

In a particular aspect of the invention the organic semiconductor layer comprises a blend of OC₁C₁₀-PPV : PCBM in weight proportions of (1:4).

A key aspect of the present invention is that the organic OC₁C₁₀-PPV : PCBM mix is dissolved in chlorobenzene or in 1,2-dichlorobenzene or xylene.

An other key aspect of the present invention lies in the fact that source and drain contacts comprises Au electrodes building a low injection barrier for the holes.

A preferred embodiment of the present invention discloses source and drain contacts, comprising a codeposition of a thin layer (< 1 nm) of Au and LiF in weight ratios varying between 10 to 1 and 1 to 10, followed by the deposition of an Al layer in order to establish a low injection barrier for holes and electrons at the same time.

In accordance with the present invention, the thin film transistor exhibits hole mobilities of 2.10⁻⁵ cm²/(Vs) and electron mobilities of 2.10⁻⁴ cm²/(Vs) as determined from the saturation regime.
In the following figures, some of the experimental results are disclosed, they are representative for the experimental device and the different mobility values of holes and electrons in the present invention.

### Short description of the drawings

Fig.1 represents a schematic device structure of the thin film transistor with top source and drain electrodes (1), an organic semiconductor layer (2), an insulation layer (3) and a gate contact (4).

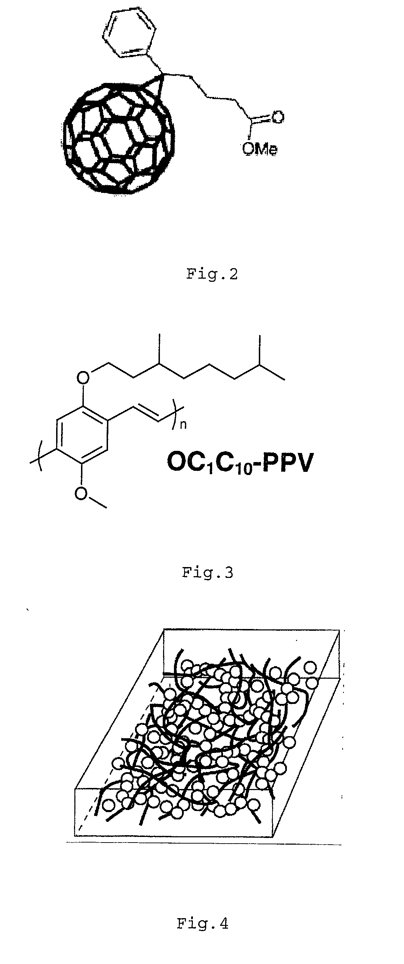

Fig.2 represents the molecule used as electron transporter. This is a modified soluble fullerene for spin coating applications, (6,6)-phenyl C₆₁-butyric acid methyl ester, (PCBM).

Fig.3 represents the molecule used as hole transporter poly(2-methoxy-5-(3',7'-dimethyloctyloxy)-1,4-phenylene-vinylene), (OC₁C₁₀-PPV).

Fig.4 represents a schematic view of the assembling of the molecules in the organic layer, building some electron and hole transport channels.

Fig.5 represents the p-channel electrical characteristics of a field-effect transistor with an active layer of a (1:4) weight ratio blend of OC₁C₁₀-PPV : PCBM and Au top contacts.

Fig.6a represents the n-channel electrical characteristics of a field-effect transistor with an active layer of a (1:4) weight ratio blend of OC₁C₁₀-PPV : PCBM and Al top contacts.

Fig.6b represents the improved n-channel electrical characteristics of a field-effect transistor with an active layer of a (1:4) weight ratio blend of OC₁C₁₀-PPV : PCBM with LiF/Al top contacts. A thin layer of LiF was evaporated on top of the organic blend prior to the deposition of the Al electrode.

Fig.7 represents the hole and electron mobilities in OC₁C₁₀-PPV : PCBM (1:4) weight ratio as determined from devices with respectively Au top contacts and LiF/Al top contacts.

Fig.8 represents the p-channel and n-channel electrical characteristics of a field-effect transistor with an active layer of a (1:4) weight ratio blend of OC₁C₁₀-PPV : PCBM with Au:LiF/Al top contacts. A thin layer of co-evaporated Au and LiF (represented as (Au:LiF)) in a (1:1) weight ratio was formed on top of the organic blend prior to the deposition of the Al electrode.

### Detailed description of the invention

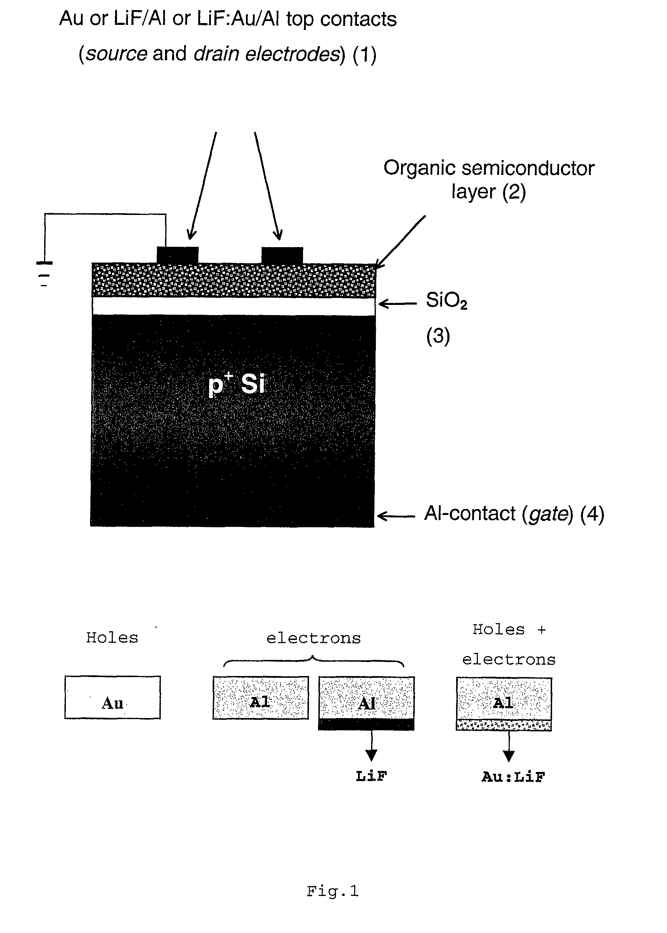

Fig.1 shows the set-up of the organic field-effect transistor and helps to understand the experimental conditions of the different steps.

In a first cleaning step, the SiO₂ surface is properly cleaned by immersing the substrate consecutively in heated acetone and heated IPA (isopropylalcohol).

In a second step a surface treatment of the SiO₂ is performed by an oxygen plasma during 5 minutes at 200 W. This step is followed by a HMDS (hexamethyldisilazane) treatment.

This treatment leads to an extremely hydrophobic SiO₂ surface and allows a suitable self-organisation of the organic molecules at the interface with SiO_{2.} The organisation of the electron and hole transporter molecules are of major importance to achieve high mobility values as it is known that an improved structural order leads to enhanced π-π stacking and hence, to an increased mobility.

The substrate is then introduced into a nitrogen box where spin coating of the organic film can be done. The presence of nitrogen keeps oxygen and moisture out of the organic film. Furthermore, the substrate can be directly transferred from the nitrogen box to the metal deposition chamber in this way avoiding the formation of an insulating metal oxide layer at the interface between the organic film and the evaporated metal.

The organic blends are prepared by dissolving OC₁C₁₀-PPV and PCBM in a (1:4) weight ratio in an organic solvent, preferably, water-free chlorobenzene, water-free 1,2-dichlorobenzene or xylene. In practice, 5mg of OC₁C₁₀-PPV and 20mg of PCBM are dissolved in 1ml of one of the above mentioned solvents. A magnetic stirring rod is added to the solution in a vessel and is kept stirring overnight at a temperature of 60 °C. The organic layer is formed by covering the SiO₂ with the solution and spincoat the surface 40s at 1200 rpm, followed by 20s at 4000 rpm. This technique supplies organic layers of suitable thickness (100 to 200 nm). A similar technique can be used for poly(3-hexylthiophene) (P3HT).

In the next step the top electrodes are evaporated through a shadow mask defining channel lengths ranging between 30 microns and 200 microns and channel widths of 2 mm or 10 mm.
Different types of top contacts can be formed:
- for hole transport: Au(100 nm)
- for electron transport: LiF(0.6 nm)/Al(120 nm)
- for electron and hole transport: Au:LiF (0.6 nm)/Al(120 nm)

In latter case first a very thin layer is formed by the co-evaporation of Au and LiF at an extremely low deposition rate, typically 0.1 Angstrom/sec or 10pm/sec for Au as well as for LiF. In this way a mixed layer of 0.6 nm Au:LiF could be formed in 30 seconds. This step is followed by the deposition of an Al layer of approximately 120 nm thickness.

The work function of Au is such that it forms an ohmic contact with the highest occupied molecular orbital (HOMO) of OC₁C₁₀-PPV, resulting in a low injection barrier for the holes.

A low injection barrier for the electrons into the lowest unoccupied (LUMO) of PCBM was realised by depositing LiF/Al drain and source contact electrodes onto the organic blend. The co-deposition of Au and LiF, followed by the deposition of Al should combine these two properties.

After the set-up of the different functional layers on the organic field-effect transistor, the samples were taken out of the deposition chamber and measured in a flow of nitrogen.

FET characterisation was performed using a HP4156A analyser, with the source contact connected to ground.

The measurement mode of the FET is determined by the gate voltage, which induces an accumulation layer of charges in the region of the conduction channel adjacent to the interface with the SiO₂.

For p-channel (n-channel) operation, a negative (positive) gate voltage is applied to induce an accumulation layer of holes (electrons), allowing the measurement of the hole (electron) mobility.
The field-effect mobilities µ_{*FE*} were calculated from the saturation regime of the drain-source current (*I*_{*ds*}) using the formula:$\text{I} {\text{}}_{{\text{ds}}_{\text{sat}}} \text{=} \frac{{\text{µ}}_{\text{FE}} {\text{WC}}_{\text{ox}}}{\text{2} \text{L}} {\left(\text{V} {\text{}}_{\text{gs}} \text{- V} {\text{}}_{\text{t}}\right)}^{\text{2}}$ where *W* and *L* are respectively the conduction channel width and length, *C*_{*ox*} is the capacitance of the insulating SiO₂ layer, *V*_{*gs*} is the gate voltage, and *V*_{*t*} is the threshold voltage.

We have determined the following mobilities:

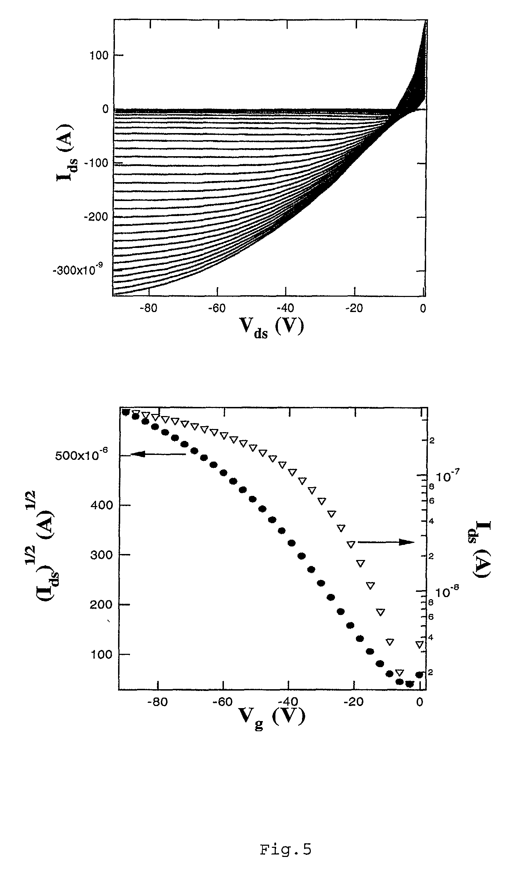

For the hole mobility, Au contacts → µₕ = 1 x 10⁻³ cm²/(Vs) (Fig. 5)

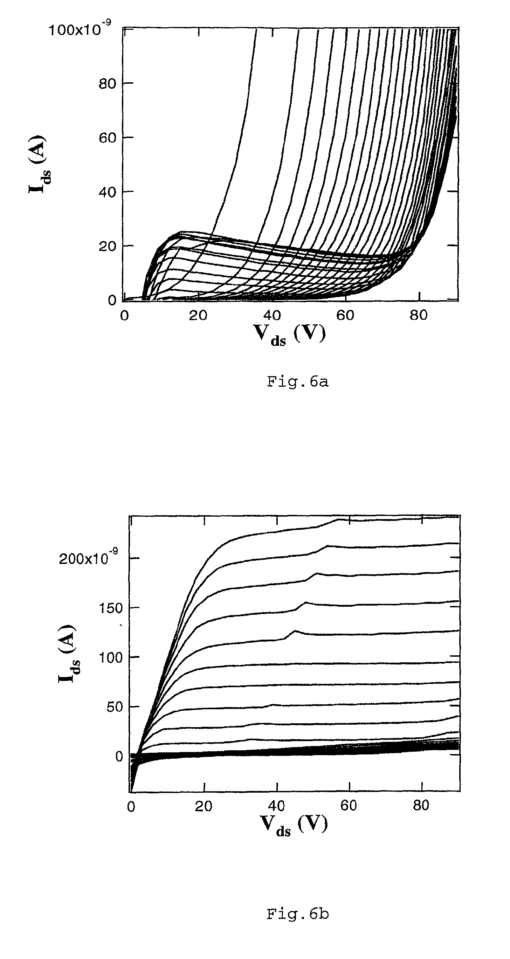

For the electron mobility, LiF/Al contacts → µₑ = 3 x 10⁻⁴ cm²/(Vs) (Fig. 6)

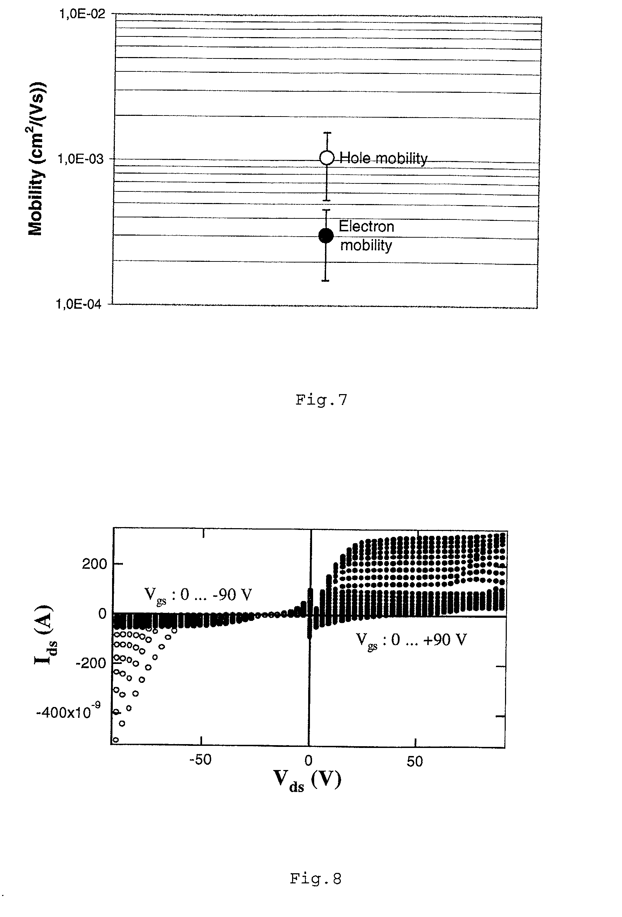

The previous mobility values are summarised in Fig. 7 with their respective error bars.

For the hole and electron mobility at the same time, Au:LiF/Al with a (1:1) ratio for (Au:LiF) → µₕ = 2 x 10⁻⁵ cm²/(Vs) and µₑ = 2 x 10⁻⁴ cm²/ (Vs) (Fig. 8).

## Claims

**1.** An organic field-effect transistor comprising source and drain electrodes (1) formed separately from each other on a substrate, said substrate comprising at least an organic semiconductor layer (2) constituting a channel between said source and drain electrodes (1), an insulation layer (3) underlying said organic semiconductor layer (2) and a gate electrode (4) formed on the opposite side of the isolation layer (3), wherein said organic semiconductor layer (2) comprises holes and electrons transporters, said electron transporter comprising (6,6)-phenyl C₆₁-butyric acid methyl ester (PCBM) and wherein said hole transporters comprising poly(2-methoxy-5-(3',7'-dimethyloctyloxy)-1,4-phenylene-vinylene) (OC₁C₁₀-PPV) and/or poly(3-hexylthiophene) (P3HT).

**2.** An organic field-effect transistor as recited in claim 1 wherein said source and drain electrodes (1) are made of at least a codeposition of Au and LiF in a variable weight ratio comprised between 1 to 10 and 10 to 1.

**3.** An organic field-effect transistor as recited in claim 2 wherein said source and drain electrodes (1) are made of at least a codeposition of Au and LiF in a variable weight ratio comprised between 1 to 4 and 4 to 1.

**4.** An organic field-effect transistor as recited in claim 2 wherein an Al layer is deposited on top of the codeposited Au:LiF layer.

**5.** An organic field-effect transistor as in claim 1 wherein that source and drain electrodes (1) comprise Au contacts as a low injection barrier for the holes.

**6.** An organic field-effect transistor as in claim 1 wherein that source and drain electrodes (1) comprise LiF/Al contacts as a low injection barrier for the electrons.

**7.** An organic field-effect transistor as recited in claim 1 wherein the organic semiconductor layer (2) comprises a blend of OC₁C₁₀-PPV : PCBM in a variable weight ratio comprised between 1 to 2 and 1 to 5.

**7.** An organic field-effect transistor as recited in claim 7 wherein the organic semiconductor layer (2) comprises traces of an organic solvent.

**8.** An organic field-effect transistor as recited in claim 8 wherein the organic semiconductor layer (2) comprises traces of chlorobenzene.

**9.** An organic field-effect transistor as recited in claim 8 wherein the organic semiconductor layer (2) comprises traces of 1,2 dichlorobenzene.

**10.** An organic field-effect transistor as recited in claim 8 wherein the organic semiconductor layer (2) comprises traces of xylene.

**11.** A process to prepare an organic field effect transistor as recited in anyone of the preceding claims, comprising the following steps:
- forming on a substrate a gate electrode (4)
- depositing on said gate electrode (4) an isolation layer preferably a SiO₂ layer,
- depositing by spin coating of a mixture of at least two components, in order to have an organic semiconductor layer (2), the first component being (6,6)-phenyl C₆₁-butyric acid methyl ester, the second component being poly(2-methoxy-5-(3',7'-dimethyloctyloxy)-1,4-phenylene-vinylene) (OC₁C₁₀-PPV) and/or poly (3-hexylthiophene) (P3HT),
- creating source and a drain electrodes (1).

**12.** A process according to claim 12 wherein the creation of said source and drain electrodes (1) is performed by a codeposition of Au and LiF in a variable weight ratio comprised between 1 to 10 and 10 to 1.

**13.** A process according to claim 13 wherein the codeposition of Au and LiF is followed by the deposition of an Al layer.

**14.** A process according to claim 12 wherein the two components of the organic semiconductor layer are dissolved in an organic solvent to be applied on the insulation layer by spin coating.
